# EUROPEAN PATENT APPLICATION

(11) **EP 4 827 271 A1**
(43) Date of publication of application: **21.10.2026**
(21) Application number: 25910229.1
(22) Date of filing: 28.09.2025
(51) Int. Cl.: H10D 62/10, H10D 30/66

(54) **SUPERJUNCTION SEMICONDUCTOR DEVICE**

(30) Priority: 23.12.2024 CN 202411896372
(71) Applicant: United Nova Technology Co., Ltd., Shaoxing, Zhejiang 312035 (CN)
(72) Inventor: LI, Baojie, Shaoxing, Zhejiang 312035 (CN); REN, Wenzhen, Shaoxing, Zhejiang 312035 (CN); CONG, Maojie, Shaoxing, Zhejiang 312035 (CN); LU, Jue, Shaoxing, Zhejiang 312035 (CN); XU, Xudong, Shaoxing, Zhejiang 312035 (CN)
(74) Representative: Kraus & Lederer PartGmbB
(86) International application number: PCT/CN2025/124934
(87) International publication number: WO 2026/138048

(57) **Abstract**

Embodiments of this application provide a superjunction semiconductor device, including: a semiconductor material layer, including an upper surface and a lower surface that are opposite to each other; a superjunction structure located in the semiconductor material layer, where the superjunction structure includes a plurality of first conductivity type pillars and second conductivity type pillars that are alternately arranged; a first conductivity type well region located in the semiconductor material layer and located at a top end of the first conductivity type pillar, where the first conductivity type well region includes a first-type well region and a second-type well region; a gate located on the upper surface; a first conductive plug, passing through the gate and conductively connected to the first-type well region; and a second conductive plug, located on the gate and conductively connected to the gate, where an upper portion of the second-type well region is overlaid by the gate, and the second-type well region is electrically isolated from both the first conductive plug and the second conductive plug; and the second-type well region extends from a core region to a terminal region, and the second-type well region is separately disposed from the first-type well region in both the core region and the terminal region.

## Description

### CROSS-REFERENCE TO RELATED APPLICATIONS

This application claims priority to Chinese Patent Application No. 202411896372.7, filed with the China National Intellectual Property Administration on December 23, 2024 and entitled "SUPERJUNCTION SEMICONDUCTOR DEVICE", which is incorporated herein by reference in its entirety.

### TECHNICAL FIELD

This application relates to the field of semiconductor technologies, and in particular, to a superjunction semiconductor device.

### BACKGROUND

Compared with a conventional metal oxide semiconductor field effect transistor (MOSFET), a superjunction MOSFET introduces N-pillars and P-pillars that are alternately arranged in a drift region, thereby greatly increasing a doping concentration of the drift region without reducing a breakdown voltage. Different from an existing vertical double-diffused metal oxide semiconductor (VDMOS) device, a specific on-resistance of the superjunction MOSFET can be further reduced by continuously reducing a distance between the P-pillars. In a case of the same on-resistance, a chip area of the superjunction MOSFET may reach less than one-sixth of that of the VDMOS, and a capacitance of the superjunction MOSFET is also sharply reduced.

In a switching process of the superjunction MOSFET, because the P-pillars and the N-pillars in the superjunction structure are depleted with only a low voltage of drain-source (Vds), a capacitance of gate-drain (Cgd) of the superjunction MOSFET exhibits a sharp decrease at a voltage of drain-source of tens of volts, and afterward, the Cgd maintains a small value. This easily causes oscillation of a gate voltage and the voltage of drain-source. The oscillation affects stability of a system and an electromagnetic interference (EMI) characteristic, generates a serious electromagnetic interference problem, and limits a large-range use of the superjunction MOSFET device. In addition, as devices become increasingly miniaturized, the Cgd also decreases with the reduction in device size, thereby exacerbating the electromagnetic interference problem.

### SUMMARY

In view of this, embodiments of this application provide a superjunction semiconductor device to resolve at least one problem existing in the background.

According to a first aspect, an embodiment of this application provides a superjunction semiconductor device, including:
a semiconductor material layer, including an upper surface and a lower surface that are opposite to each other;
a superjunction structure located in the semiconductor material layer, where the superjunction structure includes a plurality of first conductivity type pillars and second conductivity type pillars that are alternately arranged;
a first conductivity type well region located in the semiconductor material layer and located at a top end of the first conductivity type pillar, where the first conductivity type well region includes a first-type well region and a second-type well region;
a gate located on the upper surface of the semiconductor material layer;
a first conductive plug, passing through the gate and conductively connected to the first-type well region; and
a second conductive plug, located on the gate and conductively connected to the gate, where
an upper portion of the second-type well region is overlaid by the gate, and the second-type well region is electrically isolated from both the first conductive plug and the second conductive plug; and the second-type well region extends from a core region to a terminal region of the superjunction semiconductor device, and the second-type well region is separately disposed from the first-type well region in both the core region and the terminal region.

With reference to the first aspect of this application, in an optional implementation, the superjunction semiconductor device further includes:
a dielectric layer located between the gate and the upper surface of the semiconductor material layer, where
the gate includes a first gate part located directly above the first-type well region and a second gate part located directly above the second-type well region, and an average thickness of a part of the dielectric layer that is located between the second gate part and the second-type well region is greater than an average thickness of a part that is located between the first gate part and the first-type well region.

With reference to the first aspect of this application, in an optional implementation, the dielectric layer includes a gate dielectric layer and an isolation dielectric layer, where the gate dielectric layer is located between the first-type well region and the first gate part and located between the second-type well region and the second gate part, and the isolation dielectric layer is located between the second-type well region and the gate dielectric layer.

With reference to the first aspect of this application, in an optional implementation, the gate further includes a first gate connection portion located in the terminal region, and the first gate part and the second gate part are conductively connected in the terminal region through the first gate connection portion.

With reference to the first aspect of this application, in an optional implementation, the gate further includes a second gate connection portion located in the core region, where the second gate connection portion is located directly above the second conductivity type pillar;
the first gate part includes a first sub-portion and a second sub-portion that are separated in the core region by the first conductive plug, and the first sub-portion and the second sub-portion are conductively connected in the terminal region through the first gate connection portion; and
for two first gate parts adjacent to a same second gate part and respectively located on two sides of the second gate part, a second sub-portion of one first gate part is connected to the second gate part through one second gate connection portion, and a first sub-portion of an other first gate part is connected to the second gate part through an other second gate connection portion.

With reference to the first aspect of this application, in an optional implementation, the gate includes a first gate part located directly above the first-type well region and a second gate part located directly above the second-type well region, and the first gate part is electrically isolated from the second gate part.

With reference to the first aspect of this application, in an optional implementation, the gate further includes a first gate connection portion located in the terminal region;
the first gate part includes a first sub-portion and a second sub-portion that are separated in the core region by the first conductive plug, and the first sub-portion and the second sub-portion are conductively connected in the terminal region through the first gate connection portion;
for two first gate parts adjacent to a same second gate part and respectively located on two sides of the second gate part, a first gap dielectric layer exists between the second sub-portion of one first gate part and the second gate part, another first gap dielectric layer exists between a first sub-portion of an other first gate part and the second gate part, and the first gap dielectric layers are respectively located directly above different second conductivity type pillars; and
the second sub-portion of the one first gate part is conductively connected to the first sub-portion of the other first gate part in the terminal region through the first gate connection portion.

With reference to the first aspect of this application, in an optional implementation, the superjunction semiconductor device further includes:
a source region located in the first-type well region, where
no source region is disposed in the second-type well region.

With reference to the first aspect of this application, in an optional implementation, the superjunction semiconductor device further includes: a first through slot passing through the gate, where the first conductive plug is located in the first through slot, and the first through slot is further filled with a second gap dielectric layer, where
in a plane parallel to the upper surface, the first conductivity type pillars and the second conductivity type pillars are alternately arranged in a first direction, the first through slot extends in a second direction, and the second direction is perpendicular to the first direction; and in the second direction, a part of the first-type well region is in contact with the first conductive plug, and a part of the first-type well region is in contact with the second gap dielectric layer.

With reference to the first aspect of this application, in an optional implementation, distribution positions of the first conductive plug and the second gap dielectric layer in two adjacent first through slots are correspondingly the same; or
distribution positions of the first conductive plug and the second gap dielectric layer in two adjacent first through slots are correspondingly opposite.

The superjunction semiconductor device according to this embodiment of this application includes: a semiconductor material layer, including an upper surface and a lower surface that are opposite to each other; a superjunction structure located in the semiconductor material layer, where the superjunction structure includes a plurality of first conductivity type pillars and second conductivity type pillars that are alternately arranged; a first conductivity type well region located in the semiconductor material layer and located at a top end of the first conductivity type pillar, where the first conductivity type well region includes a first-type well region and a second-type well region; a gate located on the upper surface of the semiconductor material layer; a first conductive plug, passing through the gate and conductively connected to the first-type well region; and a second conductive plug, located on the gate and conductively connected to the gate, where an upper portion of the second-type well region is overlaid by the gate, and the second-type well region is electrically isolated from both the first conductive plug and the second conductive plug; and the second-type well region extends from a core region to a terminal region of the superjunction semiconductor device, and the second-type well region is separately disposed from the first-type well region in both the core region and the terminal region. In this way, the second-type well region is overlaid by the gate and is electrically isolated from both the first conductive plug and the second conductive plug, and the second-type well region is not connected to a potential. In addition, in the core region and the terminal region of the device, the second-type well region is separately disposed from the first-type well region, to prevent the second-type well region from being affected by the first-type well region to which a voltage is applied, so that the second-type well region is in a completely floating state. Therefore, during operation of the device, no voltage is applied to a first conductivity type pillar corresponding to a lower portion of the second-type well region, and the first conductivity type pillar and an adjacent second conductivity type pillar are not depleted. Only a first conductivity type pillar corresponding to the first-type well region is subjected to voltage application, generating depletion toward an adjacent second conductivity type pillar. Therefore, between the first conductivity type pillar corresponding to the lower portion of the second-type well region and the first conductivity type pillar corresponding to the first-type well region, only unidirectional depletion is generated, which greatly prolongs a time for the second conductivity type pillar between two first conductivity type pillars to be completely depleted, thereby increasing a Cgd, decelerating a decreasing trend of the Cgd, reducing a voltage oscillation, and suppressing electromagnetic interference.

Additional aspects and advantages of this application will be partially given in the following descriptions, and some will become apparent from the following descriptions, or will be learned from practices of this application.

### BRIEF DESCRIPTION OF THE DRAWINGS

The accompanying drawings described herein are used to provide a further understanding of this application, and constitute a part of this application. Exemplary embodiments of this application and descriptions thereof are used to explain this application, and do not constitute any inappropriate limitation on this application. In the accompanying drawings:
FIG. 1 is a schematic diagram of a cross-sectional structure of a superjunction semiconductor device according to the related art;
FIG. 2 is a schematic diagram of a cross-sectional structure of a superjunction semiconductor device according to an embodiment of this application;
FIG. 3 is a layout of a part of structural layers in a superjunction semiconductor device according to an embodiment of this application;
FIG. 4 is a layout of another part of structural layers in a superjunction semiconductor device according to an embodiment of this application;
FIG. 5 is a layout of another part of structural layers in a superjunction semiconductor device according to a comparative example;
FIG. 6 is a comparative diagram of Cgd-Vds curves of a superjunction semiconductor device according to an embodiment of this application and a superjunction semiconductor device according to a comparative example;
FIG. 7 is a schematic diagram of a cross-sectional structure of a superjunction semiconductor device according to an optional specific implementation;
FIG. 8 is a layout of a part of structural layers in the superjunction semiconductor device corresponding to FIG. 7;
FIG. 9 is a partial enlarged view of a cross-sectional structure of a superjunction semiconductor device according to an optional specific implementation;
FIG. 10 is a schematic diagram of a cross-sectional structure of a superjunction semiconductor device according to an optional specific implementation;
FIG. 11 is a schematic diagram of a cross-sectional structure of a superjunction semiconductor device according to another optional specific implementation;
FIG. 12 is a layout of a part of structural layers in the superjunction semiconductor device corresponding to FIG. 11;
FIG. 13 is a layout of a part of structural layers in a superjunction semiconductor device according to an optional specific example;
FIG. 14 is a layout of a part of structural layers in a superjunction semiconductor device according to another optional specific example;
FIG. 15 is a layout of a part of structural layers in a superjunction semiconductor device according to still another optional specific example; and
FIG. 16 is a layout of a part of structural layers in a superjunction semiconductor device according to yet another optional specific example.

Description of reference numerals:
100: semiconductor material layer; 101: upper surface; 102: lower surface; 110: first conductivity type pillar; 120: second conductivity type pillar; 130: first conductivity type well region; 131: first-type well region; 132: second-type well region; 140: source region; 200: gate; 210: first gate part; 211: first sub-portion; 212: second sub-portion; 220: second gate part; 230: first gate connection portion; 240: second gate connection portion; 310: first conductive plug; 320: second conductive plug; 400: dielectric layer; 410: isolation dielectric layer; 420: gate dielectric layer; 430: first gap dielectric layer; 440: second gap dielectric layer; 510: first conductive layer; 600: first through slot; 10a: core region; and 20a: terminal region.

### DETAILED DESCRIPTION

In the following descriptions, a large quantity of specific details are provided to provide a more complete understanding of this application. However, it is apparent to a person skilled in the art that this application may be implemented without one or more of these details.

In the accompanying drawings, sizes and relative sizes of layers, regions, and elements may be exaggerated for clarity. The same reference numerals denote the same elements throughout the figures.

It is to be understood that when an element or layer is referred to as being "on", "adjacent to", "connected to", or "coupled to" another element or layer, the element or layer may be directly on, adjacent to, connected to, or coupled to the another element or layer, or there may be an intermediate element or layer. On the contrary, when the element is referred to as being "directly on", "directly adjacent to", or "directly connected to", or "directly coupled to" another element or layer, there is no intermediate element or layer. It is to be understood that although terms such as "first", "second", and "third" may be used to describe various elements, components, regions, layers, and/or parts, these elements, components, regions, layers, and/or parts are not limited by these terms. These terms are only used to distinguish one element, component, region, layer, or part from another element, component, region, layer, or part. Therefore, without departing from the teaching of this application, a first element, component, region, layer, or part discussed below may be represented as a second element, component, region, layer, or part. When the second element, component, region, layer, or part is discussed, it does not indicate that the first element, component, region, layer, or part necessarily exists in this application.

Spatial relational terms such as "under", "below", "lower", "beneath", "above", and "upper" may be used herein for ease of description to describe a relationship between one element or feature shown in the figure and another element or feature. It should be understood that in addition to the orientations shown in the figures, the terms indicating the spatial relationships are also intended to include different orientations of a device in use and operation.

As used herein, "a", "an", and "the/this" in a singular form are further intended to include a plural form, unless the context clearly dictates otherwise.

To thoroughly understand this application, detailed steps and detailed structures are provided in the following descriptions, to explain the technical solutions of this application. Preferred embodiments of this application are described in detail below. However, in addition to these detailed descriptions, this application may further have other implementations.

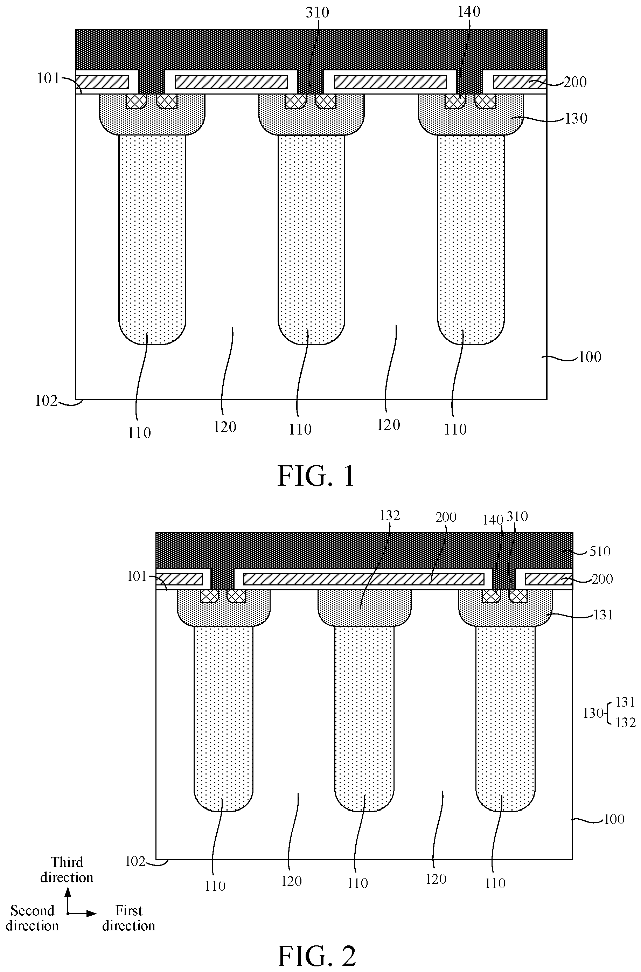

FIG. 1 is a schematic diagram of a cross-sectional structure of a superjunction semiconductor device according to the related art. As shown in the figure, a semiconductor material layer 100 includes a plurality of first conductivity type pillars 110 and second conductivity type pillars 120 that are alternately arranged; a first conductivity type well region 130 is located in the semiconductor material layer 100 and located at a top end of the first conductivity type pillar 110; a source region 140 is located in the first conductivity type well region 130; a gate 200 is located on an upper surface 101 of the semiconductor material layer 100; and a first conductive plug 310 passes through the gate 200 and is conductively connected to the source region 140.

When the device starts to operate, a channel is opened, and the first conductive plug 310 is powered on. In this case, a zero potential is applied to the source region 140. Electrons from the source region 140 pass through the channel in the first conductivity type well region 130, enter the second conductivity type pillar 120, and finally reach a drain region (not shown in the figure) located on a side of a lower surface 102 of the semiconductor material layer 100. The first conductivity type pillar 110 and the second conductivity type pillar 120 form a PN junction. In this process, a depletion region appears at an interface between the first conductivity type pillar 110 and the second conductivity type pillar 120, and as an applied voltage continuously increases, a range of the depletion region gradually increases. Since the depletion regions are formed on both sides of the second conductivity type pillar 120, depletion lines of the depletion regions on both sides gradually approach each other until they merge. After the lateral depletion is completed, the depletion regions further diffuse toward a bottom end of the first conductivity type pillar 110, and finally, the depletion lines form a straight line parallel to the lower surface 102 near the lower surface 102 of the semiconductor material layer 100.

It can be understood that, a Cgd of the device is in positive correlation with a size of the depletion region. In the device, the depletion occurs in the second conductivity type pillar 120. In a switching process, as a drain voltage increases, the depletion region gradually diffuses downward from the source region, and the Cgd of the device gradually decreases. When the depletion lines on both sides merge, the second conductivity type pillar 120 is completely depleted, the Cgd suddenly changes, and the drain voltage of the device suddenly changes in a short time, forming a voltage peak, causing a voltage oscillation, and causing verified EMI noise.

In view of this, an embodiment of this application provides a superjunction semiconductor device. Referring to FIG. 2 to FIG. 4, the superjunction semiconductor device includes: a semiconductor material layer 100, including an upper surface 101 and a lower surface 102 that are opposite to each other; a superjunction structure located in the semiconductor material layer 100, where the superjunction structure includes a plurality of first conductivity type pillars 110 and second conductivity type pillars 120 that are alternately arranged; a first conductivity type well region 130 located in the semiconductor material layer 100 and located at a top end of the first conductivity type pillar 110, where the first conductivity type well region 130 includes a first-type well region 131 and a second-type well region 132; a gate 200 located on the upper surface 101 of the semiconductor material layer 100; a first conductive plug 310, passing through the gate 200 and conductively connected to the first-type well region 131; and a second conductive plug 320, located on the gate 200 and conductively connected to the gate 200, where an upper portion of the second-type well region 132 is overlaid by the gate 200, and the second-type well region 132 is electrically isolated from both the first conductive plug 310 and the second conductive plug 320; and the second-type well region 132 extends from a core region 10a to a terminal region 20a of the superjunction semiconductor device, and the second-type well region 132 is separately disposed from the first-type well region 131 in both the core region 10a and the terminal region 20a.

In this embodiment of this application, the second-type well region 132 is overlaid by the gate 200 and is electrically isolated from both the first conductive plug 310 and the second conductive plug 320, so that the second-type well region 132 is not connected to a potential. In addition, in the core region 10a and the terminal region 20a of the device, the second-type well region 132 is separately disposed from the first-type well region 131, to prevent the second-type well region 132 from being affected by the first-type well region 131 to which a voltage is applied, so that the second-type well region 132 is in a completely floating state. Therefore, during operation of the device, no voltage is applied to a first conductivity type pillar 110 corresponding to a lower portion of the second-type well region 132, and the first conductivity type pillar and an adjacent second conductivity type pillar 120 are not depleted. Only a first conductivity type pillar 110 corresponding to the first-type well region 131 is subjected to voltage application, generating depletion toward an adjacent second conductivity type pillar 120. Therefore, between the first conductivity type pillar 110 corresponding to the lower portion of the second-type well region 132 and the first conductivity type pillar 110 corresponding to the first-type well region 131, only unidirectional depletion is generated, which greatly prolongs a time for the second conductivity type pillar 120 between the two first conductivity type pillars 110 to be completely depleted, thereby increasing a Cgd, decelerating a decreasing trend of the Cgd, reducing a voltage oscillation, and suppressing electromagnetic interference.

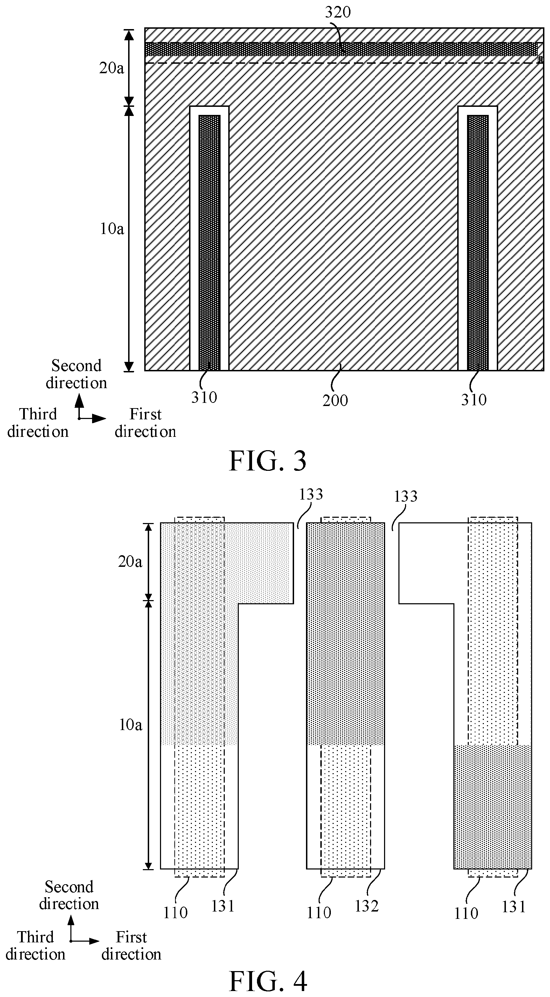

The superjunction semiconductor device includes the core region 10a and the terminal region 20a. The core region 10a is also referred to as a cell region or a device cell region, and a plurality of parallel device cells are formed in the core region 10a. The terminal region 20a surrounds a periphery of the core region 10a, and the superjunction structures are formed in both the core region 10a and the terminal region 20a. As shown in FIG. 4, the first conductivity type pillar 110 and the first conductivity type well region 130 extend from the core region 10a to the terminal region 20a. The lower portions of the first-type well region 131 and the second-type well region 132 respectively correspond to different first conductivity type pillars 110. In this embodiment, the first-type well region 131 is conductively connected to the first conductive plug 310. A cell corresponding to the first-type well region 131 may be understood as a real cell. During operation of the device, a current passes through the real cell. The upper portion of the second-type well region 132 is overlaid by the gate 200, which is electrically isolated from the first conductive plug 310, and is not applied with a potential. In addition, in the core region 10a and the terminal region 20a, the second-type well region 132 is separately disposed from the first-type well region 131. The second-type well region 132 becomes a floating well region. A cell corresponding to the second-type well region 132 may be understood as a dummy cell. During operation of the device, a current does not pass through the dummy cell.

The "floating well region" herein refers to a well region that is electrically isolated from a surrounding region and does not have a fixed potential. In this embodiment of this application, the second-type well region 132 is electrically isolated from the conductive plug, and is not applied with a voltage. Moreover, the second-type well region 132 is not connected to the first conductive plug 310 on the layout, so that the second-type well region 132 is not affected when a voltage is applied to the first-type well region 131. In this way, the second-type well region 132 is in a completely floating state. It should be further noted that, referring to FIG. 4, both the first-type well region 131 and the second-type well region 132 extend from the core region 10a to the terminal region 20a of the superjunction semiconductor device. In this embodiment of this application, the second-type well region 132 is separately disposed from the first-type well region 131 in both the core region 10a and the terminal region 20a, and the second-type well region 132 is not connected to the first-type well region 131 at any position, to be completely independent on the layout, thereby preventing the second-type well region 132 from being affected when a voltage is applied to the first-type well region 131 through the first conductive plug 310.

Therefore, it is not difficult to understand that, in the device, only the real cell is applied with the voltage, and participates in the current conduction process of the device. However, no voltage is applied to the dummy cell. In addition, the second-type well region 132 is in the completely floating state, and the dummy cell does not conduct a current as affected by the real cell. Because the depletion usually occurs at an interface of a PN junction to which a voltage is applied, and a P-doped region is expanded to an N-doped region, only the first conductivity type pillar 110 in the real cell can be depleted with the adjacent second conductivity type pillars 120, and the first conductivity type pillar 110 in the dummy cell cannot be depleted with the adjacent second conductivity type pillars 120. Therefore, in the device, the depletion only occurs on one side of the second conductivity type pillar 120. Compared with the bidirectional depletion in the related art, in this embodiment, the unidirectional depletion takes a longer time, so that the Cgd can suddenly change over a longer time period, the decreasing trend of the Cgd is decelerated, and the sudden change of the Cgd occurs when the voltage is larger. Therefore, the Cgd of the device at a high voltage is increased, and voltage overshoot is avoided.

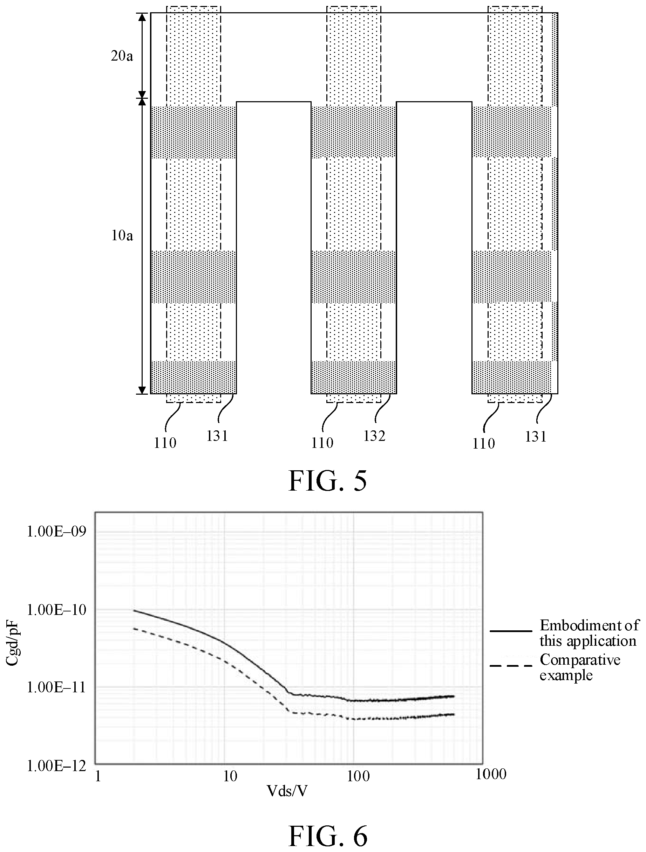

FIG. 5 is a layout of a superjunction semiconductor device according to a comparative example. It should be noted that a schematic diagram of a cross-sectional structure of the superjunction semiconductor device according to this comparative example is consistent with that in FIG. 2. Specifically, in the comparative example, the upper portion of the second-type well region 132 of the superjunction semiconductor device is overlaid by the gate 200, and the second-type well region 132 is electrically isolated from both the first conductive plug 310 and the second conductive plug 320, to form the dummy cell. However, as shown in FIG. 5, in the terminal region 20a of the device, the first-type well region 131 is connected to the second-type well region 132 instead of being electrically isolated from the second-type well region 132. In this case, the first-type well region 131 may be used to perform a conduction connection between the first conductive plug 310 and the second-type well region 132. During operation of the device, a current may also pass through the dummy cell, and both sides of the second conductivity type pillar 120 start to be depleted, affecting an improvement effect for the Cgd. Referring to FIG. 6, at the same voltage value, the Cgd of the superjunction semiconductor device according to this embodiment of this application is greater than the Cgd of the superjunction semiconductor device according to the comparative example. It can be learned that, in this embodiment of this application, the second-type well region 132 is separately disposed from the first-type well region 131 in both the core region 10a and the terminal region 20a, so that the second-type well region 132 is in the completely floating state, which can effectively improve the Cgd of the device and decelerate the decreasing trend of the Cgd.

In this embodiment, the semiconductor material layer 100 may be a semiconductor layer doped with N-type ions or P-type ions, which is formed on a substrate (not shown in the figure) well-known by a person skilled in the art, such as a silicon substrate, a silicon-on-insulator substrate, a silicon-germanium substrate. The semiconductor material layer 100 may be a structure formed by stacking a plurality of epitaxial layers. In a specific optional implementation, the semiconductor material layer 100 is doped with N-type ions, and the semiconductor material layer 100 is an N-doped layer.

Referring to FIG. 2 and FIG. 4, in the semiconductor material layer 100, in a plane parallel to the upper surface 101, the first conductivity type pillars 110 and the second conductivity type pillars 120 are alternately arranged in a first direction; the first conductivity type pillar 110 and the second conductivity type pillar 120 extend from the core region 10a to the terminal region 20a in a second direction; and the first conductivity type pillar 110 and the second conductivity type pillar 120 extend in a third direction. In this embodiment, the second direction is a direction from the core region 10a to the terminal region 20a, the third direction is a thickness direction of the semiconductor material layer 100, and any two of the first direction, the second direction, and the third direction are perpendicular to each other. It can be understood that, during actual preparation, first conductivity type ion injection may be performed on a side of the upper surface 101 of the semiconductor material layer 100, to form the first conductivity type pillar 110 in the semiconductor material layer 100 having the second conductivity type. In this case, the second conductivity type pillar 120 may be understood as a part of the semiconductor material layer 100 that is between adjacent first conductivity type pillars 110 and that is not further doped. Alternatively, second conductivity type ion injection may be performed on a side of the upper surface 101 of the semiconductor material layer 100, to form the second conductivity type pillar 120 in the semiconductor material layer 100 having the first conductivity type. In this case, the first conductivity type pillar 110 may be understood as a part of the semiconductor material layer 100 that is between adjacent second conductivity type pillars 120 and that is not further doped. In this embodiment, the semiconductor material layer 100 has the second conductivity type.

In this embodiment, the first conductivity type is specifically a P-type, and the second conductivity type is specifically an N-type. The first conductivity type pillar 110 may be referred to as a "P-pillar", the second conductivity type pillar 120 may be referred to as an "N-pillar", and the first conductivity type well region 130 may be referred to as a "P-well".

Optionally, a second-type well region 132 is disposed between adjacent first-type well regions 131. It can be understood that a plurality of cells are usually disposed in the device. That a second-type well region 132 is disposed between adjacent first-type well regions 131 can be understood that a dummy cell is disposed between adjacent real cells, so that the entire device is unidirectionally depleted, thereby more effectively increasing a depletion time, decelerating the decreasing trend of the Cgd, improving the Cgd, facilitating current uniformization, and ensuring device performance.

In this embodiment, the top end refers to an end toward the upper surface 101 of the semiconductor material layer 100, and the bottom end refers to an end toward the lower surface 102 of the semiconductor material layer 100. Therefore, that the first conductivity type well region 130 is located at a top end of the first conductivity type pillar 110 means that the first conductivity type well region 130 is located at one end of the first conductivity type pillar 110 that is toward the upper surface 101 of the semiconductor material layer 100. During actual preparation, the first conductivity type ion injection may be performed on the side of the upper surface 101 of the semiconductor material layer 100, to form the first conductivity type well region 130 at the top end of the first conductivity type pillar 110; a width of the first conductivity type well region 130 is greater than a width of the first conductivity type pillar 110; and a doping concentration of the first conductivity type well region 130 is greater than a doping concentration of the first conductivity type pillar 110.

Referring to FIG. 4, both the first-type well region 131 and the second-type well region 132 extend from the core region 10a to the terminal region 20a. The first-type well region 131 further extends toward the second-type well region 132 in the terminal region 20a. The second-type well region 132 is separately disposed from the first-type well region 131 in both the core region 10a and the terminal region 20a. As seen from the layout, the second-type well region 132 is not connected to the first-type well region 131 at any position, and the layout is completely independent. In some embodiments, the device may further include a second conductivity type doped region 133. The first-type well region 131 is isolated from the second-type well region 132 through the second conductivity type doped region 133. Therefore, it can be ensured that the first-type well region 131 and the second-type well region 132 are independent of each other. Specifically, the second conductivity type doped region 133 is located at a top end of the second conductivity type pillar 120. The second conductivity type doped region 133 and the second conductivity type pillar 120 may both be parts of the semiconductor material layer 100 that are not further doped.

Referring to FIG. 2, the device may further include: a source region 140 located in the first-type well region 131, where no source region 140 is disposed in the second-type well region 132. Therefore, during operation of the device, an effective channel cannot be formed in the second-type well region 132, and the dummy cell does not participate in the current conduction process of the device, which helps prolong the depletion time. The source region 140 has the second conductivity type. During actual preparation, the second conductivity type ion injection may be performed on the side of the upper surface 101 of the semiconductor material layer 100, to form the source region 140 in the first-type well region 131. In this case, ion injection does not need to be performed on the second-type well region 132.

Referring to FIG. 2 and FIG. 3, the device may further include: a first conductive layer 510 located above the gate 200, where the first conductive layer 510 is in direct contact with the first conductive plug 310, and is conductively connected to the first-type well region 131 through the first conductive plug 310; and a second conductive layer (not shown in the figure) located above the gate 200, where the second conductive layer is in direct contact with the second conductive plug 320, and is conductively connected to the gate 200 through the second conductive plug 320, where the first conductive layer 510 is electrically isolated from the second conductive layer; and the second-type well region 132 is electrically isolated from both the first conductive layer 510 and the second conductive layer. Because the source region 140 is formed in the first-type well region 131, the first conductive plug 310 is conductively connected to the source region 140, and the first conductive layer 510 may be referred to as a "source electrode" or an "emitter electrode". The second conductive plug 320 passes through a dielectric layer above the gate 200 and is conductively connected to the gate 200. The second conductive layer may be referred to as a "gate electrode" or a "collector electrode". Therefore, the first conductive layer 510 and the second conductive layer are used as electrodes of different polarities of the device, and need to be electrically isolated from each other, to avoid short circuits that affect device performance.

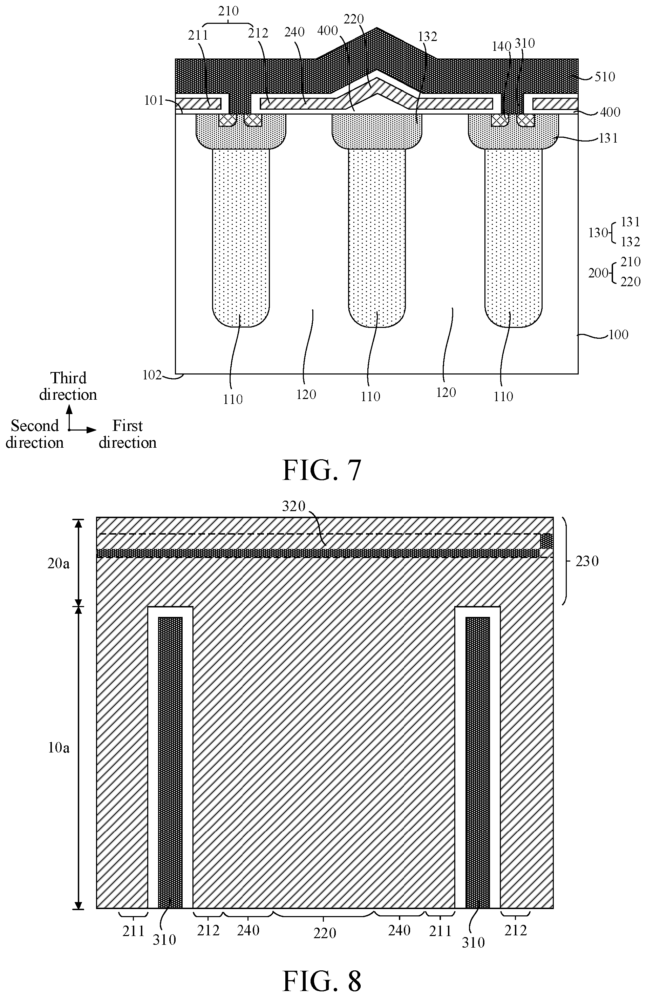

Referring to FIG. 7 and FIG. 8, in some embodiments of this application, a superjunction semiconductor device includes: a semiconductor material layer 100, including an upper surface 101 and a lower surface 102 that are opposite to each other; a superjunction structure located in the semiconductor material layer 100, where the superjunction structure includes a plurality of first conductivity type pillars 110 and second conductivity type pillars 120 that are alternately arranged; a first conductivity type well region 130 located in the semiconductor material layer 100, where the first conductivity type well region 130 includes a first-type well region 131 and a second-type well region 132, and the first-type well region 131 and the second-type well region 132 are respectively located at top ends of different first conductivity type pillars 110; a gate 200 located on the upper surface 101 of the semiconductor material layer 100; a first conductive plug 310, passing through the gate 200 and conductively connected to the first-type well region 131; a second conductive plug 320, located on the gate 200 and conductively connected to the gate 200, where an upper portion of the second-type well region 132 is overlaid by the gate 200, and the second-type well region 132 is electrically isolated from both the first conductive plug 310 and the second conductive plug 320; and a dielectric layer 400 located between the gate 200 and the upper surface 101 of the semiconductor material layer 100, where the gate 200 includes a first gate part 210 located directly above the first-type well region 131 and a second gate part 220 located directly above the second-type well region 132, and an average thickness of a part of the dielectric layer 400 that is located between the second gate part 220 and the second-type well region 132 is greater than an average thickness of a part that is located between the first gate part 210 and the first-type well region 131. It can be understood that, as shown in FIG. 8, in the device, the second conductive plug 320 is conductively connected to the gate 200. After the second conductive plug 320 is powered on, under a gate voltage, the dummy cell may be powered on, to form a depletion region. Therefore, by thickening the average thickness of the part of the dielectric layer 400 that is located between the second gate part 220 and the second-type well region 132, an isolation effect of the dielectric layer 400 can be enhanced, impact of the gate 200 on a lower dummy cell can be reduced, and the second-type well region 132 can be ensured to be in a floating state.

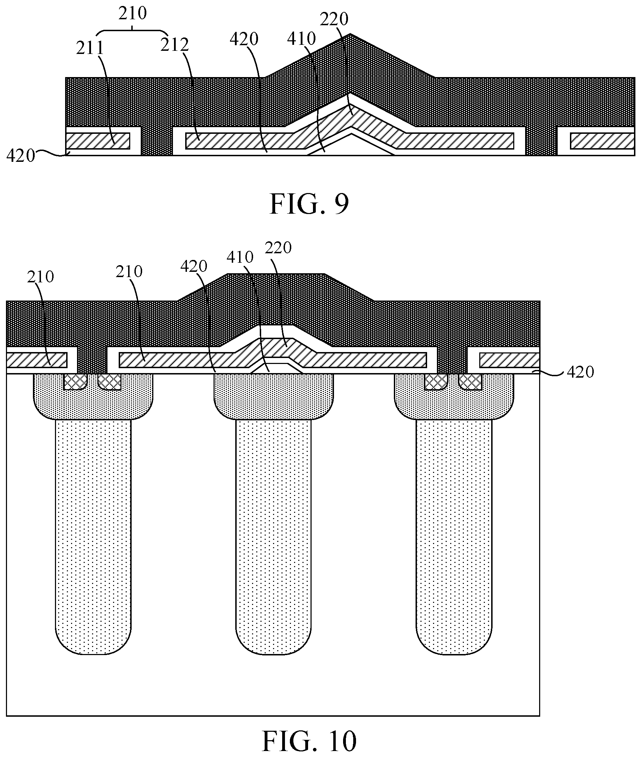

Optionally, referring to FIG. 9, the dielectric layer 400 includes a gate dielectric layer 420 and an isolation dielectric layer 410. The gate dielectric layer 420 is located between the first-type well region 131 and the first gate part 210 and located between the second-type well region 132 and the second gate part 220. The isolation dielectric layer 410 is located between the second-type well region 132 and the gate dielectric layer 420. Therefore, the isolation dielectric layer 410 is disposed above the second-type well region 132, so that the average thickness of the part of the dielectric layer that is located between the second gate part 220 and the second-type well region 132 is greater than the average thickness of the part that is located between the first gate part 210 and the first-type well region 131, thereby reducing the impact of the gate on the lower dummy cell. It can be understood that because the gate dielectric layer 420 needs to be formed above both the first-type well region 131 and the second-type well region 132, during actual preparation, the isolation dielectric layer 410 may be first formed in a region that requires thickening, and then the gate dielectric layer 420 is uniformly formed, so that in a region with a greater thickness, the isolation dielectric layer 410 is located below the gate dielectric layer 420 and the gate 200, and the gate dielectric layer 420 may be conformally formed on the isolation dielectric layer 410. Specific process conditions and the like may be the same as those in a conventional process, to reduce process difficulty.

A material of the isolation dielectric layer 410 may be any suitable dielectric material, such as silicon oxide, silicon nitride, or silicon oxynitride. In this embodiment, the material of the isolation dielectric layer 410 is specifically an oxide. The process of forming the isolation dielectric layer 410 may include a field oxide process, a local oxidation of silicon (LOCOS) process, or a deposition process. It can be understood that FIG. 7 only schematically shows some regions of the device. During actual preparation, the dielectric layer also needs to be prepared in another region of the device. Therefore, when the dielectric layer in the another region is prepared, a part of the dielectric layer that is located on the second-type well region 132 may be reserved, to form the isolation dielectric layer 410 in the same process step, thereby saving a process step.

Referring to FIG. 9 and FIG. 10, a cross-sectional shape of the isolation dielectric layer 410 may include a triangular shape or a trapezoidal shape. It can be understood that when the cross-sectional shape of the isolation dielectric layer 410 is the trapezoidal shape, the thickness of the isolation dielectric layer 410 is more uniform everywhere, and the isolation effect is better. It can be understood that during actual preparation, different processes may be used to obtain the isolation dielectric layers 410 having different cross-sectional shapes.

A material of the gate dielectric layer 420 may be any suitable dielectric material, such as silicon oxide, silicon nitride, or silicon oxynitride. In this embodiment, the material of the gate dielectric layer 420 may be specifically an oxide. The process of forming the gate dielectric layer 420 may include a deposition process.

Optionally, referring to FIG. 8, the gate further includes a first gate connection portion 230 located in a terminal region 20a, and the first gate part 210 is conductively connected to the second gate part 220 in the terminal region 20a through the first gate connection portion 230.

Specifically, referring to FIG. 7, the gate further includes a second gate connection portion 240 located in a core region 10a, and the second gate connection portion 240 is located directly above the second conductivity type pillar 120. The first gate part 210 includes a first sub-portion 211 and a second sub-portion 212 that are separated in the core region 10a by the first conductive plug 310, and the first sub-portion 211 is conductively connected to the second sub-portion 212 in the terminal region 20a through the first gate connection portion 230. For two first gate parts 210 adjacent to a same second gate part 220 and respectively located on two sides of the second gate part 220, the second sub-portion 212 of one first gate part 210 is connected to the second gate part 220 through one second gate connection portion 240, and a first sub-portion 211 of an other first gate part 210 is connected to the second gate part 220 through an other second gate connection portion 240. Two source regions 140 are formed in the first-type well region 131. The two source regions 140 are arranged at an interval in a first direction. The first sub-portion 211 and the second sub-portion 212 are respectively located in well regions between the two source regions 140 and the second conductivity type pillars 120. After the device is turned on, a channel is formed in the first conductivity type well region 130 below the first sub-portion 211 and the second sub-portion 212. Therefore, the first sub-portion 211 is conductively connected to the second sub-portion 212 in the terminal region 20a through the first gate connection portion 230. The second conductive plug 320 may be conductively connected to the first sub-portion 211 and the second sub-portion 212 through the first gate connection portion 230, to provide a gate voltage for the two sub-portions, so that the channel can be successfully formed, thereby ensuring functional implementation of the real cell.

In addition, the second sub-portion 212 of the one first gate part 210 is connected to the second gate part 220 through the one second gate connection portion 240, and the first sub-portion 211 of the other first gate part 210 is connected to the second gate part 220 through the other second gate connection portion 240. With reference to FIG. 8, as seen from the layout, the first sub-portion 211, the second sub-portion 212, the second gate connection portion 240, and the second gate part 220 form an integral structure. In the core region 10a, the first conductive plugs 310 are spaced apart by the gate. Therefore, during actual preparation, a gate material layer overlying the core region 10a and the terminal region 20a may be directly formed, and during subsequent preparation of the first conductive plug 310, a corresponding part of the gate material layer is further etched to form the gate 200, which is consistent with a conventional gate preparation process and is consistent with a gate layout of a common superjunction MOSFET. Due to the isolation dielectric layer 410, the impact of the gate on the lower dummy cell is reduced. Based on this, the foregoing setting of the gate can reduce process difficulty, and a structure such as a mask does not need to be additionally prepared, thereby saving process costs and ensuring device performance.

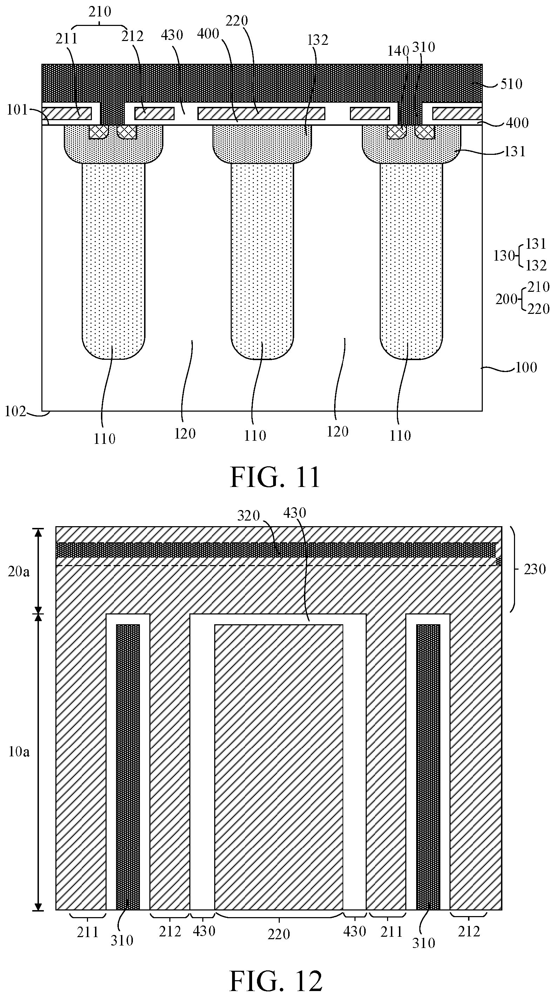

Referring to FIG. 11 and FIG. 12, in some embodiments of this application, a superjunction semiconductor device includes: a semiconductor material layer 100, including an upper surface 101 and a lower surface 102 that are opposite to each other; a superjunction structure located in the semiconductor material layer 100, where the superjunction structure includes a plurality of first conductivity type pillars 110 and second conductivity type pillars 120 that are alternately arranged; a first conductivity type well region 130 located in the semiconductor material layer 100, where the first conductivity type well region 130 includes a first-type well region 131 and a second-type well region 132, and the first-type well region 131 and the second-type well region 132 are respectively located at top ends of different first conductivity type pillars 110; a gate 200 located on the upper surface 101 of the semiconductor material layer 100, where the gate 200 includes a first gate part 210 located directly above the first-type well region 131 and a second gate part 220 located directly above the second-type well region 132, and the first gate part 210 is electrically isolated from the second gate part 220; a first conductive plug 310, passing through the first gate part 210 and conductively connected to the first-type well region 131, where an upper portion of the second-type well region 132 is overlaid by the second gate part 220, to cause the first conductive plug 310 to be electrically isolated from the second-type well region 132; and a second conductive plug 320 located on the gate 200, where the second conductive plug 320 is conductively connected to the first gate part 210, and is electrically isolated from the second gate part 220. Therefore, the first gate part 210 above the dummy cell is electrically isolated from the second gate part 220 above the real cell, to prevent the first gate part 210 from being affected when a voltage is applied to the second gate part 220, thereby reducing impact of the gate on the dummy cell.

Specifically, optionally, the superjunction semiconductor device further includes a first gap dielectric layer 430. The first gap dielectric layer 430 is at least partially disposed between the first gate part 210 and the second gate part 220, and is located directly above the second conductivity type pillar 120.

Specifically, optionally, the gate further includes a first gate connection portion 230 located in a terminal region 20a. The first gate part 210 includes a first sub-portion 211 and a second sub-portion 212 that are separated in a core region 10a by the first conductive plug 310, and the first sub-portion 211 is conductively connected to the second sub-portion 212 in the terminal region 20a through the first gate connection portion 230. For two first gate parts 210 adjacent to a same second gate part 220 and respectively located on two sides of the second gate part 220, a first gap dielectric layer 430 exists between the second sub-portion 212 of one first gate part 210 and the second gate part 220, another first gap dielectric layer 430 exists between a first sub-portion 211 of an other first gate part 210 and the second gate part 220, and the first gap dielectric layers 430 are respectively located directly above different second conductivity type pillars 120. The second sub-portion 212 of the one first gate part 210 is conductively connected to the first sub-portion 211 of the other first gate part 210 in the terminal region 20a through the first gate connection portion 230. Therefore, the first gate part 210 is electrically isolated from the second gate part 220 through the first gap dielectric layer 430.

Two source regions 140 are formed in the first-type well region 131, and the first sub-portion 211 and the second sub-portion 212 are respectively located in well regions between the two source regions 140 and the second conductivity type pillars 120. After the device is turned on, a channel is formed in the first conductivity type well region 130 below the first sub-portion 211 and the second sub-portion 212. Therefore, the first sub-portion 211 is conductively connected to the second sub-portion 212 in the terminal region 20a through the first gate connection portion 230, and the second conductive plug 320 may be conductively connected to the first sub-portion 211 and the second sub-portion 212 through the first gate connection portion 230, to provide a gate voltage for the two sub-portions, so that the channel can be successfully formed, thereby ensuring functional implementation of the real cell. In addition, the first gap dielectric layer 430 is disposed directly above the second conductivity type pillar 120, to prevent the first gap dielectric layer 430 from extending to the first-type well region 131, affecting channel formation, and further affecting device performance.

The second sub-portion 212 of the one first gate part 210 is disposed, to be conductively connected to the first sub-portion 211 of the other first gate part 210 in the terminal region 20a through the first gate connection portion 230, which helps implement parallel connection of different real cells. In this case, when the first gate connection portion 230 is connected to two real cells, the first gate connection portion 230 crosses the dummy cell. Referring to FIG. 12, the first gap dielectric layer 430 may be further disposed between the first gate connection portion 230 and the second gate part 220, to ensure electrical isolation between the first gate part 210 and the second gate part 220.

Specifically, optionally, the gate further includes a first gate connection portion 230 located in the terminal region 20a, where the first gate connection portion 230 is conductively connected to the first gate part 210; and the superjunction semiconductor device further includes a first gap dielectric layer 430, where the first gap dielectric layer 430 is at least partially disposed between the first gate connection portion 230 and the second gate part 220, to ensure electrical isolation between the first gate part 210 and the second gate part 220.

Specifically, optionally, the second conductive plug 320 is conductively connected to the first gate part 210 through the first gate connection portion 230.

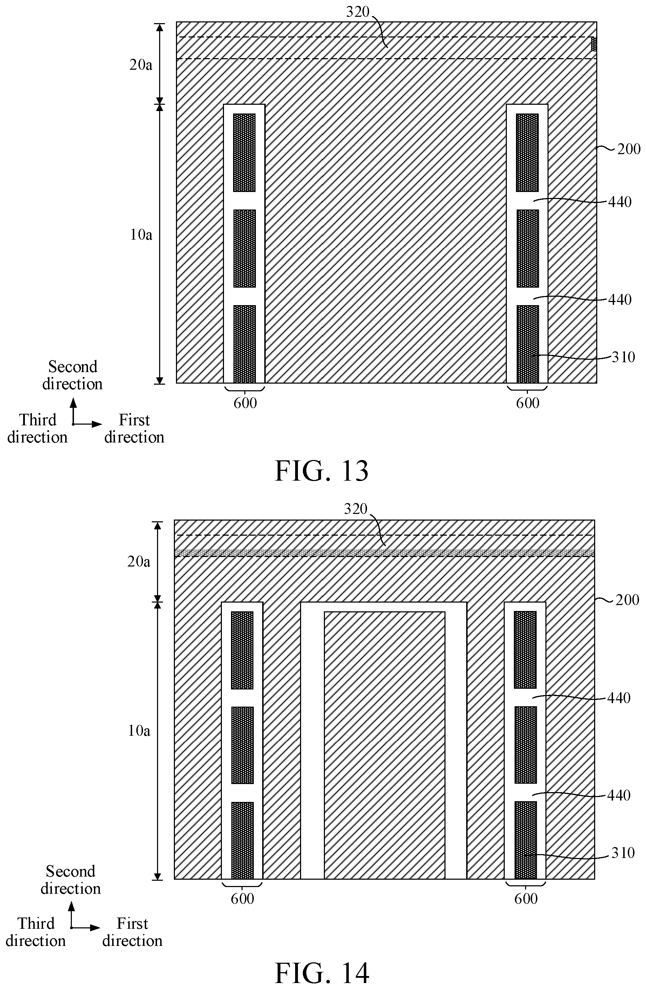

Referring to FIG. 2 and FIG. 13 to FIG. 16, in some embodiments of this application, the superjunction semiconductor device further includes: a first through slot 600 passing through the gate 200, where the first conductive plug 310 is located in the first through slot 600, and the first through slot 600 is further filled with a second gap dielectric layer 440, where in a plane parallel to the upper surface 101, the first conductivity type pillars 110 and the second conductivity type pillars 120 are alternately arranged in a first direction, the first through slot 600 extends in a second direction, and the second direction is perpendicular to the first direction; and in the second direction, a part of the first-type well region 131 is in contact with the first conductive plug 310, and a part of the first-type well region 131 is in contact with the second gap dielectric layer 440. FIG. 13 to FIG. 16 are compared with FIG. 3. It can be understood that, compared with that all of the first-type well region 131 is in contact with the first conductive plug 310, a part of the first-type well region 131 is disposed to be in contact with the first conductive plug 310, and a part of the first-type well region 131 is disposed to be in contact with the second gap dielectric layer 440, so that an area of the first conductive plug 310 is reduced, and an area of a conductive region is reduced. In this case, the part of the real cell that is in contact with the first conductive plug 310 is actually conductive, and the part of the real cell that is in contact with the second gap dielectric layer 440 is conductive as affected by another part, which may be understood as being indirectly conductive. Therefore, when the first conductive plug 310 is powered on, a current conduction speed of the part of the real cell that is indirectly conductive is slow, thereby further prolonging the depletion time, decelerating the decreasing trend of the Cgd, increasing the Cgd of the device, and improving the electromagnetic interference immunity of the device.

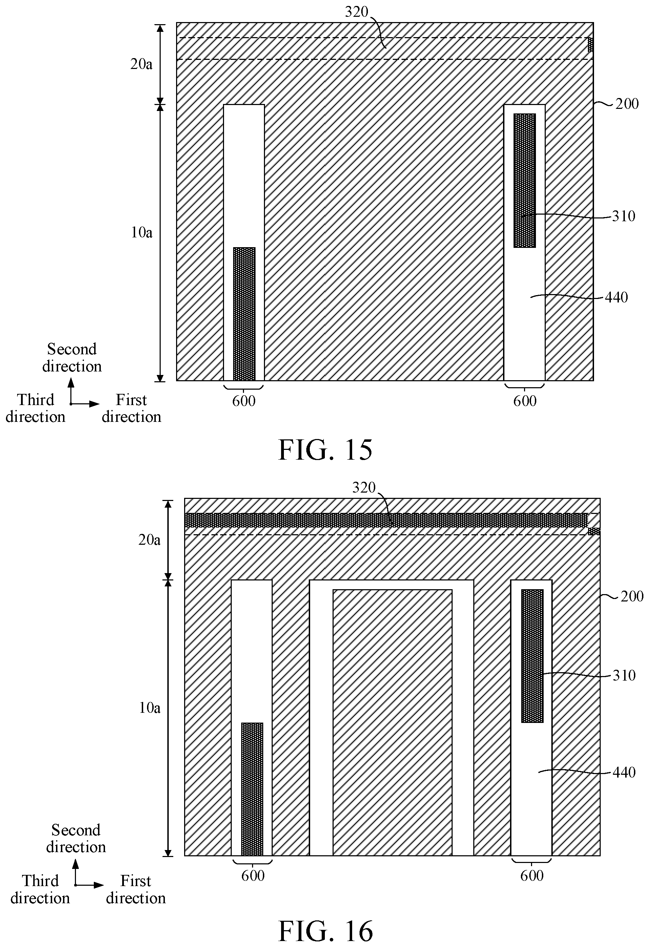

Further, referring to FIG. 13 and FIG. 14, distribution positions of the first conductive plug 310 and the second gap dielectric layer 440 in two adjacent first through slots 600 are correspondingly the same. Alternatively, referring to FIG. 15 and FIG. 16, distribution positions of the first conductive plug 310 and the second gap dielectric layer 440 in two adjacent first through slots 600 are correspondingly opposite. Therefore, while the area of the conductive region is reduced, distributions of conductive regions of two adjacent real cells are correspondingly the same or opposite, which presents an axially symmetric distribution or a centrally symmetric distribution, thereby achieving current uniformization, and ensuring device performance.

It is to be understood that the foregoing embodiments are all exemplary, and are not intended to include all possible implementations. Various modifications and changes may further be made based on the foregoing embodiments without departing from the scope of the present disclosure. Similarly, technical features of the foregoing embodiments may alternatively be randomly combined to form another embodiment of this application that may not be explicitly described. Therefore, the foregoing embodiments only describe several implementations of this application, and are not intended to limit the protection scope of this application.

## Claims

1. A superjunction semiconductor device, comprising:
a semiconductor material layer, comprising an upper surface and a lower surface that are opposite to each other;
a superjunction structure located in the semiconductor material layer, wherein the superjunction structure comprises a plurality of first conductivity type pillars and second conductivity type pillars that are alternately arranged;
a first conductivity type well region located in the semiconductor material layer and located at a top end of the first conductivity type pillar, wherein the first conductivity type well region comprises a first-type well region and a second-type well region;
a gate located on the upper surface of the semiconductor material layer;
a first conductive plug, passing through the gate and conductively connected to the first-type well region; and
a second conductive plug, located on the gate and conductively connected to the gate, wherein
an upper portion of the second-type well region is overlaid by the gate, and the second-type well region is electrically isolated from both the first conductive plug and the second conductive plug; and the second-type well region extends from a core region to a terminal region of the superjunction semiconductor device, and the second-type well region is separately disposed from the first-type well region in both the core region and the terminal region.

2. The superjunction semiconductor device according to claim 1, further comprising:
a dielectric layer located between the gate and the upper surface of the semiconductor material layer, wherein
the gate comprises a first gate part located directly above the first-type well region and a second gate part located directly above the second-type well region, and an average thickness of a part of the dielectric layer that is located between the second gate part and the second-type well region is greater than an average thickness of a part that is located between the first gate part and the first-type well region.

3. The superjunction semiconductor device according to claim 2, wherein the dielectric layer comprises a gate dielectric layer and an isolation dielectric layer, wherein the gate dielectric layer is located between the first-type well region and the first gate part and located between the second-type well region and the second gate part, and the isolation dielectric layer is located between the second-type well region and the gate dielectric layer.

4. The superjunction semiconductor device according to claim 2 or 3, wherein the gate further comprises a first gate connection portion located in the terminal region, and the first gate part and the second gate part are conductively connected in the terminal region through the first gate connection portion.

5. The superjunction semiconductor device according to claim 4, wherein
the gate further comprises a second gate connection portion located in the core region, wherein the second gate connection portion is located directly above the second conductivity type pillar;
the first gate part comprises a first sub-portion and a second sub-portion that are separated in the core region by the first conductive plug, and the first sub-portion and the second sub-portion are conductively connected in the terminal region through the first gate connection portion; and
for two first gate parts adjacent to a same second gate part and respectively located on two sides of the second gate part, a second sub-portion of one first gate part is connected to the second gate part through one second gate connection portion, and a first sub-portion of an other first gate part is connected to the second gate part through an other second gate connection portion.

6. The superjunction semiconductor device according to claim 1, wherein the gate comprises a first gate part located directly above the first-type well region and a second gate part located directly above the second-type well region, and the first gate part is electrically isolated from the second gate part.

7. The superjunction semiconductor device according to claim 6, further comprising:
a first gap dielectric layer, wherein the first gap dielectric layer is at least partially disposed between the first gate part and the second gate part, and is located directly above the second conductivity type pillar.

8. The superjunction semiconductor device according to claim 6, wherein
the gate further comprises a first gate connection portion located in the terminal region, wherein the first gate connection portion is conductively connected to the first gate part; and
the superjunction semiconductor device further comprises a first gap dielectric layer, wherein the first gap dielectric layer is at least partially disposed between the first gate connection portion and the second gate part, to ensure electrically isolation between the first gate part and the second gate part.

9. The superjunction semiconductor device according to claim 6, wherein
the gate further comprises a first gate connection portion located in the terminal region;
the first gate part comprises a first sub-portion and a second sub-portion that are separated in the core region by the first conductive plug, and the first sub-portion and the second sub-portion are conductively connected in the terminal region through the first gate connection portion;
for two first gate parts adjacent to a same second gate part and respectively located on two sides of the second gate part, a first gap dielectric layer exists between a second sub-portion of one first gate part and the second gate part, another first gap dielectric layer exists between a first sub-portion of an other first gate part and the second gate part, and the first gap dielectric layers are respectively located directly above different second conductivity type pillars; and
the second sub-portion of the one first gate part is conductively connected to the first sub-portion of the other first gate part in the terminal region through the first gate connection portion.

10. The superjunction semiconductor device according to claim 8 or 9, wherein the second conductive plug is electrically connected to the first gate part through the first gate connection portion.

11. The superjunction semiconductor device according to claim 1, wherein one second-type well region is disposed between adjacent first-type well regions.

12. The superjunction semiconductor device according to claim 1, further comprising:
a second conductivity type doped region, wherein the first-type well region and the second-type well region are isolated through the second conductivity type doped region.

13. The superjunction semiconductor device according to claim 1, further comprising:
a source region located in the first-type well region, wherein
no source region is disposed in the second-type well region.

14. The superjunction semiconductor device according to claim 1, further comprising: a first through slot passing through the gate, wherein the first conductive plug is located in the first through slot, and the first through slot is further filled with a second gap dielectric layer, wherein
in a plane parallel to the upper surface, the first conductivity type pillars and the second conductivity type pillars are alternately arranged in a first direction, the first through slot extends in a second direction, and the second direction is perpendicular to the first direction; and in the second direction, a part of the first-type well region is in contact with the first conductive plug, and a part of the first-type well region is in contact with the second gap dielectric layer.

15. The superjunction semiconductor device according to claim 14, wherein
distribution positions of the first conductive plug and the second gap dielectric layer in two adjacent first through slots are correspondingly the same; or
distribution positions of the first conductive plug and the second gap dielectric layer in two adjacent first through slots are correspondingly opposite.
